# FASCICULE DE BREVET EUROPEEN

(11) **EP 3 491 899 B1**
(45) Date de publication et mention de la délivrance du brevet: **02.11.2022**
(21) Numéro de dépôt: 17754425.1
(22) Date de dépôt: 28.07.2017
(51) Int. Cl.: H05K 3/10, H05K 3/32

(54) **DISPOSITIF EMETTEUR DE LUMIERE ET SON PROCEDE DE FABRICATION**
LICHTEMITTIERENDE VORRICHTUNG UND VERFAHREN ZUR HERSTELLUNG DAVON
LIGHT-EMITTING DEVICE AND METHOD FOR MANUFACTURING SAME

(30) Priorité: 28.07.2016 FR 1657333
(43) Date de publication de la demande: 05.06.2019
(73) Titulaire: Linxens Holding, 78200 Mantes-la-Jolie (FR)
(72) Inventeur: EYMARD, Eric, 43000 Polignac (FR); MATHIEU, Christophe, 78200 Mantes La Jolie (FR); DESCHAMPS, Jérôme, 63170 Aubiere (FR)
(74) Mandataire: Cabinet Laurent & Charras
(86) Numéro de dépôt international: PCT/FR2017/052130
(87) Numéro de publication internationale: WO 2018/020185

(56) Documents cités:
- EP-A1- 2 991 460
- DE-A1-102012 221 250
- US-A1- 2003 010 065
- US-A1- 2010 116 526
- US-A1- 2014 209 942
- US-A1- 2014 268 607
- US-A1- 2015 129 909

## Description

### Domaine technique

L'invention se rapporte à un dispositif émetteur de rayonnement lumineux dans lequel des dispositifs lumineux LED formés de diodes électroluminescentes (LED) sont montés sur un circuit imprimé.

### Technique antérieure

De façon simplifiée, une puce LED (pour « Light Emitting Diode » en anglais) comprend classiquement au moins une jonction *p-n* formée entre une zone de matériau semi-conducteur dopé selon un dopage de type *p* et une zone de matériau semi-conducteur dopé selon un dopage type n. Des bornes de connexion électrique reliées à chacune des zones dopées permettent l'alimentation de la LED par injection d'un courant et donc l'émission de rayonnement lumineux dans une gamme de longueurs d'onde. Par ailleurs, la puce LED peut être associée à des luminophores aptes à absorber une partie des rayons lumineux émises par la LED et à émettre des rayons lumineux dans une autre gamme de longueurs d'onde.

On distingue plusieurs types de configuration de puces LED qui se différencient essentiellement par la méthode d'alimentation de la LED et notamment par la disposition des bornes de connexion électrique.

Dans une première configuration dite « verticale », les zones semi-conductrices *p* et n sont formées les deux faces opposées d'une embase électriquement conductrice. L'ensemble forme un empilement surmonté d'une première borne de connexion électrique, l'embase formant la deuxième borne de connexion électrique. Ainsi, dans cette configuration, le courant traverse tout l'empilement, y compris l'embase.

Dans une deuxième configuration dite « horizontale », les bornes de connexion sont nécessairement formées sur les deux zones dopées. En particulier, les zones semi-conductrices *p* et *n* sont formées sur une même face d'une embase, généralement un substrat de croissance peu conducteur électriquement. En pratique, les bornes de connexion sont disposées sensiblement sur un même plan ou légèrement décalées dans le sens de la hauteur (ou de l'épaisseur des zones), de sorte que le courant traverse la zone active du semi-conducteur sans traverser l'embase peu conductrice.

Dans une troisième configuration dite « flip-chip », l'alimentation électrique de la puce est assurée par des plots de soudure électriquement conducteurs (ou « solder bump» en anglais) disposées sur un même plan pour éviter l'utilisation de fils de connexion.

Classiquement, une ou plusieurs puces LED peuvent être disposées sur une face d'un substrat et peuvent être enrobées, avec éventuellement des luminophores, dans un corps d'encapsulation, en résine de silicone par exemple, pour former un module LED. Des plages de contact reliées électriquement aux électrodes des puces LED sont alors généralement prévues sur le substrat pour permettre la connexion électrique du module LED avec d'autres composants d'un circuit.

En outre, ces dispositifs de type LED, à savoir les puces LED ou les modules LED, sont généralement reportés sur un circuit imprimé formé d'un support sur lequel sont routées des pistes électriques conductrices selon un motif d'interconnexion prédéfini.

Par exemple, pour réaliser un circuit imprimé flexible adapté au report de puces ou modules LED, les pistes conductrices peuvent être formées par lamination d'un film conducteur sur une surface d'un support flexible suivi d'une gravure chimique de ce film. Cependant, cette technique de routage empreinte aux technologies soustractives n'autorise que des motifs très limités puisqu'un motif incluant un chevauchement des pistes n'est pas permis. En outre, elle ne permet pas de graver des pistes sur des surfaces très importantes.

Une solution similaire consiste à réaliser les pistes conductrices par découpe mécanique du film conducteur avant la lamination plutôt que par gravure chimique après la lamination sur une surface du support. Cette technique de routage (« leadframe » selon la terminologie anglo-saxonne) possède les mêmes limitations in-fine que la technique de gravure chimique.

Une autre solution empreinte aux technologies additives consiste en l'utilisation d'encre conductrice imprimée sur le support. Cette solution présente cependant une moins bonne performance car la conductivité des encres est moindre que celle des métaux. La conductivité des pistes dépendant de l'épaisseur du film d'encre déposé, il est parfois nécessaire d'appliquer plusieurs couches successives d'encre, rendant la solution plus coûteuse. En outre, en fonction de la qualité de l'encre et de l'impression, la densité des pistes du circuit imprimé n'est pas optimale. Par ailleurs, tout comme le routage par gravure, la sérigraphie n'autorise pas de façon aisée le chevauchement des pistes car au moins trois séquences d'impressions successives sont nécessaires pour réaliser un pont isolant.

Le report des dispositifs LED peut être obtenu par brasage collectif incluant un passage au four, après placement des dispositifs LED sur le circuit imprimé. Cette technique limite cependant l'utilisation à un certain type de matériau pour le support flexible et peut causer des dommages à certains composants du fait de l'utilisation d'une température de fusion relativement élevée (typiquement dans la plage 250-350°C). Une autre solution consiste à mettre en œuvre une technique de microcâblage (ou « wire bonding ») qui nécessite cependant un grand nombre de manipulations, et engendre une épaisseur non négligeable sur le circuit imprimé.

Un autre problème majeur des dispositifs LED montés sur circuit imprimé est l'évacuation de la chaleur générée par la LED. Une mauvaise dissipation thermique peut notamment entraîner le vieillissement prématuré des composants ainsi qu'une chute de l'efficacité du système. Classiquement, la dissipation thermique peut être assurée par les pistes conductrices elles-mêmes, mais cette gestion thermique n'est pas optimale notamment pour les puces LED à fort courant d'alimentation qui nécessite une surface d'échange thermique plus importante que celle offerte par les pistes conductrices. Une solution consiste alors à adjoindre au circuit des radiateurs plus ou moins encombrants et plus ou moins coûteux. Les documents US 2015/129909, US2014/268607, US2003/010065 et US2010/116526 illustrent les techniques connues.

### Exposé de l'invention

Dans ce contexte, la présente invention vise donc à proposer une solution alternative pour la réalisation de dispositif émetteur de rayonnement lumineux d'une ou plusieurs longueurs d'ondes, exempt des inconvénients listés ci-dessus.

En particulier, la présente invention vise à proposer une nouvelle solution pour le routage de pistes conductrices sur support, flexible ou rigide, adapté pour l'interconnexion électrique des dispositifs de type LED, tels que des puces LED ou des modules LED. En outre, la présente invention vise également à proposer une solution moins complexe autorisant le routage d'une plus grande densité de pistes conductrices sur un support, souple ou rigide, ainsi qu'une plus grande flexibilité en termes de motifs d'interconnexion. La présente invention propose également une solution qui autorise un routage sur des surfaces plus importantes, ainsi qu'une plus grande densité de modules et/ou puces LED tout en réduisant l'encombrement global de l'ensemble. La présente invention offre également la possibilité de monter un faible nombre de dispositifs LED sur une très grande surface de support pour un coût moindre.

Un autre objectif de l'invention est de proposer une solution moins encombrante et moins coûteuse pour la dissipation thermique des dispositifs LED montés sur un circuit imprimé. En particulier, la présente invention offre une modularité dans les moyens qui peuvent être mis en œuvre pour la dissipation thermique.

L'invention a ainsi pour objet un dispositif émetteur d'un rayonnement lumineux, visible ou non, comprenant au moins un dispositif de type LED et un support qui peut être par exemple flexible ou rigide. Le dispositif de type LED est apte à générer un rayonnement lumineux dans une gamme de longueurs d'onde prédéfinie, et comprend au moins deux plages de contact électrique. Le support est délimité par des première et deuxième faces opposées définissant entre elles une épaisseur du support. Ce support porte au moins le dispositif lumineux LED et au moins une piste électrique conductrice.

Selon l'invention, la piste électrique est formée de fils conducteurs solidarisés au support sur tout ou partie de leur longueur. Tout ou partie des fils conducteurs présentent au moins une portion de contact exposée ou libre en direction d'au moins l'une des première et deuxième faces du support. En outre, chacune des plages de contact du dispositif de type LED est positionnée en regard d'une portion de contact d'un des fils conducteurs et est connectée électriquement à cette portion de contact.

Ainsi, la solution de l'invention consiste à router les pistes conductrices sur un support, qui peut être flexible ou non, par solidarisation de simple fils conducteurs au support. Ces fils conducteurs s'étendent de préférence sensiblement dans un même plan sensiblement parallèle à l'une des première ou deuxième faces du support. Ces fils conducteurs sont notamment calibrés en fonction de leur utilisation. Par exemple ces fils conducteurs peuvent être destinés à l'alimentation électrique du ou des dispositifs LED, à l'interconnexion électrique d'un dispositif LED avec d'autres dispositifs LED ou avec d'autres composants, à la transmission de données, ou encore à la formation de composant électrique passif ou à la formation de radiateur. En particulier, certains fils conducteurs présentent une ou de plusieurs portions de contact réparties sur le long du fil. Ces portions de contact sont notamment destinées à être connecté directement aux plages de contact des dispositifs LED. Par conséquent, le routage des pistes conductrices, la connexion électrique des dispositifs de type LED sur le support ainsi que l'interconnexion électrique entre plusieurs dispositifs de type LED montés sur le support, s'en trouvent ainsi simplifiés.

Selon un mode de réalisation de l'invention, ledit support du dispositif émetteur de l'invention peut présenter au moins une zone déformable dans au moins une direction de déformation, une portion d'au moins l'un desdits fils conducteurs étant positionnée dans ladite zone étirable selon un motif autorisant la déformation de ladite zone déformable et de la piste conductrice dans ladite direction de déformation, sans induire une rupture des fils conducteurs routé sur le support. La déformation de la zone peut notamment correspondre à un étirement/élongation, torsion ou encore rétractation dans une ou plusieurs directions de l'espace.

De préférence, tout ou partie des fils conducteurs présente une portion positionnée selon ledit motif autorisant la déformation et une portion de contact, ces deux types de portions étant distinctes les unes des autres. De préférence, le motif autorisant la déformation est obtenu sans discontinuité du fil conducteur. En d'autres termes, les fils conducteurs présentant les deux types de portions peuvent servir à la fois à assurer la conduction électrique mais également à assurer une meilleure flexibilité ou élasticité de la piste conductrice. Ainsi, la piste conductrice peut suivre les déformations potentielles du support sans risque de rupture de ligne, c'est-à-dire que la fonction relative à la conductivité électrique du fil conducteur est conservée même après les déformations, à savoir étirements et/ou rétractations et/ou torsion du support, suite à une mise en forme du dispositif émetteur de l'invention.

En pratique, il peut être envisagé de positionner les fils conducteurs selon un motif autorisant une déformation telle que définie ci-avant, de la zone déformable dudit support de plusieurs millimètres par zone, par exemple une déformation supérieure à 2 cm sur 4 zones de déformations, sans provoquer de rupture de ligne. De tels motifs peuvent être par exemple du type présentant au moins une courbe, comme par exemple du type en zigzag ou encore en cercle, en spirale. Bien entendu, d'autres motifs sont envisageables en fonction des contraintes de déformations souhaitées du support.

Ainsi, il est tout à fait possible d'envisager de réaliser dans un premier temps le dispositif lumineux tel que décrit ci-avant en positionnant l'ensemble piste conductrice et dispositifs de type LED sur le support et, dans un deuxième temps, de déformer le dispositif lumineux ainsi obtenu pour obtenir une structure en volume, par exemple par moulage ou thermoformage. Les motifs autorisant la déformation apportent à la piste conductrice une meilleure résistance aux contraintes de déformation tout en évitant la rupture de ligne.

Selon un mode de réalisation, tout ou partie des fils conducteurs peuvent être positionnés dans l'épaisseur du support. En particulier, la section de chaque fil conducteur peut être positionnée dans l'épaisseur du support en tout ou partie. En d'autres termes, le fil peut être intégralement dans l'épaisseur du support, ou effleurer la surface du support ou être légèrement en saillie par rapport à cette surface.

Selon une variante de ce mode de réalisation, chaque fil conducteur peut être incrusté dans l'épaisseur du support à partir d'une face d'incrustation formée par la première ou la deuxième face du support. En outre, les portions de contact de chaque fil conducteur sont de préférence exposées en direction d'au moins cette face d'incrustation pour ce fil.

Ainsi, la solution selon cette variante consiste à router les pistes conductrices sur un support, qui peut donc être flexible ou non, en incrustant des fils conducteurs dans l'épaisseur de ce support. En d'autres termes, tout ou partie des fils conducteurs est logé, sur toute sa longueur ou sur une grande partie de sa longueur, dans le support. La profondeur de l'incrustation dans l'épaisseur du support peut être telle que tout ou partie des fils conducteurs présentent au moins une portion de contact exposée ou libre en direction de la face d'incrustation et destinée à être reliée ou connectée directement aux plages de contact des dispositifs de type LED. Le routage des fils conducteurs via une technique d'incrustation est avantageux pour fixer solidement les fils au support.

Cette variante permet notamment de positionner le ou les dispositifs LED de plusieurs manières sur le support.

Par exemple, le dispositif LED peut être positionné sur la surface du support et plus précisément sur la face d'incrustation correspondante pour le fil auquel le dispositif LED est connecté. Ainsi, les plages de contact peuvent passer sur ou sous les plages de contact du dispositif LED.

Bien entendu, il est possible de router le support sur ses première et deuxième faces et de monter des dispositifs de type LED sur ces deux faces pour obtenir un dispositif émetteur émettant des rayonnements dans plusieurs directions et notamment à partir des deux faces du support. Avantageusement, le support peut donc comprendre, sur sa première face, au moins une première piste conductrice et au moins un dispositif de type LED connecté électriquement à la première piste conductrice et, sur sa deuxième face, au moins un autre dispositif de type LED connecté électriquement à la première piste et/ou éventuellement à une ou plusieurs autres pistes conductrices de la deuxième face.

Par exemple, le dispositif LED peut également être positionné dans un logement ou cavité réalisé dans l'épaisseur du support, ce logement pouvant être traversant ou non. Ainsi, le support peut être pourvu d'au moins un logement ouvert sur au moins l'une des faces du support, ce logement comprenant au moins le dispositif de type LED et au moins les portions de contact auxquelles ce dispositif de type LED est connecté. Avantageusement, le logement peut également être ouvert sur la face d'incrustation du fil qu'il reçoit. De même, les plages de contact peuvent passer sur ou sous les plages de contact du dispositif LED. Tout comme précédemment, il est possible de prévoir des logements sur les deux faces opposées du support et de router ces deux faces opposées pour obtenir un dispositif émettant des rayonnements dans plusieurs directions et notamment à partir des deux faces du support.

Le logement peut également être traversant, c'est-à-dire ouvert sur les deux faces opposées du support. Dans ce cas particulier, il est possible de positionner un ou plusieurs dispositifs LED dans le logement. En outre chaque dispositif LED peut être monté de manière à émettre en direction de l'une ou l'autre des faces du support. Il est ainsi possible de réaliser un dispositif émetteur émettant des rayonnements à partir des deux faces du support. Cette solution permet notamment de réduire l'encombrement et réaliser des objets lumineux fin et flexible émettant dans plusieurs directions.

En pratique donc :
- les portions de contact peuvent être exposées sur au moins la première face du support, et notamment la face d'incrustation ou rendues disponibles pour être connectées électriquement en fonction du schéma électrique envisagé ;
- les portions de contact peuvent également être exposées dans un logement réalisé dans le support ;
- les portions de contact peuvent être exposées sur les deux faces opposées du support, notamment lorsque le logement est traversant c'est-à-dire ouvert sur les deux faces opposées du support.

Bien entendu, une combinaison de ces variantes est également possible sur un même support. Le dispositif émetteur peut comprendre plusieurs dispositifs LED, chacun pouvant être monté au support selon l'une des variantes présentées ci-dessus. Bien entendu, il est possible de combiner les différentes variantes sur un même support.

Par ailleurs, le routage des pistes conductrices et le montage du dispositif LED sur le support peuvent être réalisés de plusieurs manières. En particulier, il est possible de fixer le dispositif LED sur le support avant de réaliser le routage des pistes, et il est également possible de réaliser les pistes conductrices sur le support avant le montage du dispositif LED sur le support. On comprend donc que la solution de l'invention consistant à mettre en œuvre l'incrustation de fils conducteurs offre une très grande flexibilité dans le processus de fabrication. Ainsi, les portions de contact et les plages de contact peuvent être connectées entre elles par tous moyens, comme par exemple ceux décrit ci-après, par exemple par collage, par une technique de soudage par thermocompression, ou encore par « clipsage » des portions de contact dans les plages de contact.

Selon une autre variante de ce mode de réalisation, le support peut être formé de deux substrats enserrant les fils conducteurs. En d'autres termes, les fils conducteurs sont en sandwich entre les deux substrats formant le support.

En pratique, pour laisser échapper le rayonnement lumineux émis par le dispositif LED, au moins l'un des deux substrats comporte au moins un évidement autorisant l'exposition des portions de contact et la connexion électrique des plages de contact du dispositif LED, le dispositif LED étant positionné à l'intérieur de cet évidement.

En pratique, il est également possible qu'au moins l'un des deux substrats du support présente des propriétés optiques, par exemple être transparent pour le rayonnement émis par le dispositif LED, ou encore être diffusante pour une diffusion homogène des rayonnements.

Selon un autre mode de réalisation, les fils conducteurs sont posés sur l'une des première et/ou deuxième faces du support et sont solidarisés à cette face.

En d'autres termes, le routage de la piste conductrice est obtenu par simple pose des fils conducteur sur le support, par exemple par collage, suivant un motif d'interconnexion prédéfini. Selon une autre variante, le routage de la piste conductrice peut être obtenu par lamination d'une piste conductrice préalablement réalisée par découpe d'un film conducteur selon un schéma électrique incluant ledit motif autorisant la déformation.

Pour assurer une meilleure fixation des fils au support, il est possible d'enserrer les fils conducteurs et le dispositif de type LED entre le support et une couche ou plaque de maintien. Tout comme précédemment, la couche de maintien peut recouvrir toute la surface du support et présenter dans ce cas des propriétés optiques autorisant notamment la diffusion des rayonnements lumineux émis par le dispositif LED ou encore être pourvue d'évidements pour laisser échapper ces rayonnements.

Cette solution présente notamment l'avantage de permettre d'utiliser des supports de très grande surface et de réaliser des objets à faible coût.

Les solutions proposées ci-dessus offrent donc une très grande flexibilité quant à la disposition des dispositifs LED sur le support et quant à la variété et au nombre de dispositifs LED qu'il est possible de monter sur un même support.

En particulier, le dispositif de type LED peut comprendre une ou plusieurs puces LED ou une ou plusieurs LED packagées, intégrant chacune au moins deux électrodes formant les plages de contact. Chacune de ces électrodes est connectée électriquement à une des portions de contact des fils conducteurs.

Avantageusement, la puce LED peut être d'abord positionnée sur le support du dispositif émetteur selon l'une des variantes décrites ci-dessus, et connectée aux portions de contact selon l'une des manières explicitées ci-dessus, puis encapsulée dans un corps d'encapsulation. Le corps d'encapsulation qui peut être à base de résine de silicone, recouvre ainsi de préférence au moins la puce LED et une partie des fils conducteurs connectés à la puce LED. En pratique, au moins un matériau luminophore peut également être disposé dans le corps d'encapsulation avec la puce LED. Des particules diffusantes et/ou des luminophores peuvent également être intégrés dans la résine de silicone. Bien entendu, plusieurs puces LED peuvent être disposées dans un même corps d'encapsulation.

Par exemple, le dispositif LED peut être une puce LED, typiquement à configuration « horizontale », comprenant deux électrodes formées sur une même face d'une embase électriquement isolante. Ces électrodes forment ainsi les deux plages de contact mentionnées ci-dessus et sont chacune connectée électriquement à une des portions de contact.

Le dispositif de type LED peut également comprendre un module LED intégrant une ou plusieurs LED packagée ou encore une ou plusieurs puces LED associées ou non à des luminophores disposés sur un substrat, chaque puce LED étant encapsulée dans un corps d'encapsulation commun ou distinct, les deux plages de contact de chaque puce LED étant positionnées sur le substrat et étant reliées électriquement aux électrodes de la puce LED. Tout comme précédemment, le module LED peut être positionné sur le support selon l'une des variantes décrites ci-dessus, et connectée aux portions de contact selon l'une des manières explicitées ci-dessus. Bien entendu, des modules LED à base de puces LED à configuration « verticale » ou en « flip-chip » peuvent également être utilisés.

Bien entendu, la solution présentée ci-dessus autorise également le montage de plusieurs dispositifs de type LED et/ou plusieurs autres composants électroniques sur le support, et interconnectés entre eux au moyen de la piste conductrice.

Ainsi, tout ou partie des dispositifs LED peuvent être montés en série et/ou en parallèle, et chaque fil conducteur peut notamment être continu et/ou discontinu entre deux ou plusieurs plages de contact en fonction du schéma électrique souhaité.

On comprend donc que la solution de l'invention consistant à utiliser des fils conducteurs, comme par exemple des fils de cuivre, qui peuvent être routés par incrustation ou par simple collage offre une très grande flexibilité dans le processus de fabrication, dans le choix du matériau du support, dans le motif d'interconnexion, ainsi que dans la densité de dispositifs LED montés au support.

Par ailleurs, un autre avantage de l'utilisation de fils conducteurs réside dans le fait qu'il est possible de former des composants électriques passifs à l'aide d'au moins un des fils conducteurs de la piste conductrice. Par exemple, il est possible de former une résistance par enroulement d'un des fils conducteurs. En outre, il est également possible de former un dissipateur thermique ou radiateur à l'aide d'au moins un des fils conducteurs ou un autre fil dédié incrusté dans le support via la même technique. Ainsi, avantageusement, la piste conductrice peut comprendre au moins une résistance et/ou un dissipateur thermique formé par au moins un des fils conducteurs. Certains fils conducteurs de la piste conductrice peuvent être spécifiquement utilisés pour former des résistances ou des radiateurs, notamment via des enroulements denses. Néanmoins, un même fil peut être utilisé pour former une ou des résistances et/ou un ou des radiateurs ainsi que un ou plusieurs portions de contact permettant d'interconnecter électriquement plusieurs dispositifs LED entre eux.

De tels avantages et possibilités ne se retrouvent pas dans les techniques conventionnellement utilisées pour le routage sur support, à savoir la gravure, la découpe ou le dépôt d'encre conductrice, pour la réalisation de circuit imprimé adapté au montage de dispositifs LED.

Par ailleurs, indépendamment de la dissipation thermique via les fils conducteurs, il est possible de prévoir une ou des plages thermiques spécifiques, à base d'un matériau conducteur thermique, à disposer sur le support. Par exemple, une plage thermique peut être obtenue par le dépôt d'une couche thermiquement conductrice sur tout ou partie de la surface du support, ou encore dans les logements lorsque ces derniers sont présents. Par exemple, il est possible de coller une ou des feuilles à base d'un matériau thermiquement conducteur sur le support. Il est également possible de prévoir des plaques thermiques à disposer en contact ou non avec un ou plusieurs portions de contact de manière à offrir une plus grande surface d'échange thermique aux dispositifs LED. Ces plages thermiques peuvent être solidarisées aux portions de contact par différents moyens, comme par exemple ceux décrit ci-après pour la connexion des plages de contact des dispositifs LED, par exemple par soudure par thermocompression ou par point de colle.

En pratique, l'incrustation des fils conducteurs dans l'épaisseur du support peut être réalisée selon un procédé par ultrasons dans lequel des vibrations sont générées par ultrasons et sont appliquées aux fils conducteurs. Une autre technique d'incrustation peut consister à réaliser des sillons dans l'épaisseur du support à partir de l'une des faces opposées du support, puis à insérer tout ou partie de ces fils conductrices dans ces sillons. De préférence, au moins les portions de contact des fils conducteurs peuvent effleurer la surface de la première face du support ou peuvent être légèrement en saillie par rapport à cette surface.

Par ailleurs, la connexion électrique des plages de contact du dispositif de type LED avec les portions de contact des fils conducteurs, peut être réalisée via un soudage par thermocompression (« Thermo-Compression Bonding TCB » selon la terminologie anglo-saxonne). Bien entendu, il est possible d'envisager d'autres techniques comme par exemple l'utilisation de gouttes de colle conductrice, de film adhésif conducteur isotropique ou anisotropique (« ACF » sous forme de fil selon la terminologie anglo-saxonne ou « ACP » sous forme de pate), ou de pâte à braser (« solder paste » selon la terminologie anglo-saxonne). Il est également possible d'envisager une fixation et une connexion des portions de contact aux plages de contact via un système de « clipsage » des portions de contact dans les plages de contact. Par exemple, chaque plage de contact peut intégrer une broche dans laquelle vient s'emboîter la portion de contact.

En particulier, la plupart des puces ou modules LED présentent généralement des plages de contact de dimensions inadaptées pour la mise en œuvre de la technique de soudage par thermocompression, notamment lorsque les pistes conductrices ont été réalisée par la technique d'incrustation des fils ou par collage des fils. Il est donc nécessaire de prévoir un support spécifique qui soit capable de recevoir un ou plusieurs de ces puces ou modules LEDs et qui soit adapté pour une connexion électrique sur la piste conductrice, par exemple via une des techniques de connexion définies ci-avant. Ainsi, la présente invention a également pour objet un support pour dispositif LED adapté pour être monté au support du dispositif émetteur de lumière présenté ci-dessus. Le support pour dispositif LED comprend notamment un substrat apte à recevoir au moins une puce LED, packagée ou non, ou un module LED. Le substrat comprend au moins une structure de réception et au moins une paire de structures de connexion. La structure de réception reçoit une ou plusieurs puces LED ou un ou plusieurs modules LED. Chaque structure de connexion est formée d'au moins d'une première portion solidaire d'une deuxième portion. La première portion est reliée électriquement à l'une des électrodes de la puce LED ou du module LED, et la deuxième portion forme une plage de contact destinée à être connectée directement, via par exemple une soudure par thermocompression, à un fils conducteurs d'une piste conductrice. Ainsi, la structure de réception peut recevoir plusieurs puces LED, packagée ou non, émettant sensiblement dans une même longueur d'onde ou dans des longueurs d'ondes différentes. Bien entendu, la forme et la taille des structures de réception et de connexion peuvent varier en fonction de l'application ou de la densité de LED sur le support. Par ailleurs, le nombre de structures de connexion peut également varier. Ainsi, il est possible de prévoir une paire de structures de connexion commune à toutes les puces LED, ou plusieurs paires de structures de connexion distinctes. Par exemple, il peut être envisagé une première portion commune à tout ou partie des puces et modules LED, ou des premières portions de la structure de connexion distinctes pour les puces ou modules LED. Par exemple, il peut également être envisagé une deuxième portion commune à tout ou partie des puces et modules LED, ou des deuxièmes portions distinctes pour les puces ou modules LED. L'utilisation de ce type de support pour LED associée notamment au routage par incrustation ou collage permet d'avoir une densité de LEDs bien supérieure sur le support du dispositif lumineux de l'invention. Selon une variante, le substrat présente une structure centrale et deux structures latérales, ladite structure centrale recevant au moins la puce ou module LED, chaque structure latérales étant formée d'une première portion solidaire d'une deuxième portion, la première portion étant reliée électriquement à l'une des électrodes de la puce LED, et la deuxième portion formant la plage de contact et étant connectée à l'une des portions de contact d'un des fils conducteurs de la piste conductrice.

Par exemple, le dispositif émetteur de l'invention peut comprendre un dispositif de type LED formé du support pour dispositif LED présenté ci-dessus et un ou plusieurs puces ou modules LED disposés sur la structure de réception, et connectés aux premières portions des structures de connexion. Les deuxièmes portions des structures de connexion forment ainsi les plages de contact connectées aux portions de contact de la piste conductrice.

En pratique, les fils conducteurs peuvent être à base d'un matériau métallique. A titre d'exemple, les fils conducteurs peuvent par exemple être en cuivre, or, aluminium, argent ou en alliage à base d'au moins l'un de ces métaux. Il est également possible d'envisager d'utiliser tout autre type de fils à base d'un matériau conducteur électrique, comme par exemple des fils à base de carbone, notamment en graphite. Par ailleurs, chaque fil conducteur peut avoir une section quelconque, notamment parallélépipédique ou ronde. Par exemple, le diamètre de la section du fil conducteur peut être typiquement de l'ordre du dixième de millimètre, par exemple 80 ou 120 µm. En pratique, chaque fil conducteur est dimensionné pour s'adapter à l'utilisation à laquelle le fil est destiné. De façon classique, chaque fil conducteur peut être dimensionné en fonction du schéma électrique à router dans le support, des différents composants à interconnecter, de l'intensité du courant ou de la puissance à véhiculer. Ainsi, il est possible d'avoir, sur un même support, des fils conducteurs de dimensions différentes, tels que des fils adaptés pour des puissances électriques plus ou moins importantes, ou encore des fils destinés à la transmission de données, ou encore des fils adaptés pour la formation de résistances ou de radiateurs.

En outre, chaque fil conducteur peut être recouvert ou non d'une gaine isolante. Lorsque le fil conducteur est recouvert d'une couche isolante, les portions de contact destinées à être connectées aux plages de contact du dispositif LED sont de préférence dépourvues de la couche isolante. En d'autres termes, le fil conducteur gainé peut comprendre une ou plusieurs portions de contact bien distinctes. L'utilisation de fil conducteur gainé permet notamment de réaliser des motifs incluant le chevauchement des fils. A titre d'exemple, du fil conducteur en cuivre émaillé peut être utilisé. En pratique, il est possible de prévoir une étape spécifique d'élimination de la couche isolante des portions de contact, en mettant par exemple en œuvre des techniques d'élimination mécanique ou chimique. A titre d'exemple, la couche isolante peut être éliminée par abrasion, dissolution, ou sublimation à température adaptée.

Les fils conducteurs peuvent également être revêtus d'une couche de finition destinée à augmenter la réflectivité. A titre d'exemple, la couche de finition peut être en or, argent, aluminium, cuivre, palladium ou en alliage à base de l'un de ces métaux.

Différents matériaux peuvent être utilisés pour le support du dispositif émetteur de l'invention. De préférence, le support est en matériau électriquement isolant, souple ou rigide. A titre d'exemple, le support peut être en matériau à base d'époxy, par exemple en verre-époxy ou à base de polymère thermoplastique, par exemple en PolyChlorure de Vinyle (PVC) mélangé ou non avec de l'Acrylonitrile Butadiène Styrène (ABS), en polyester ou polyimide. Les matériaux décrit dans le document US 2014/0268607A1 peuvent également être envisagés. Par exemple, l'utilisation d'un matériau élastomère permet notamment d'obtenir un dispositif émetteur présentant une sensibilité faible aux vibrations. En outre, pour augmenter la réflectivité, le support peut être de couleur blanc teinté dans la masse, revêtu d'une couche de finition à effet miroir, par exemple en alliage à base de nickel, d'or, de palladium, d'argent, etc.

Avantageusement, le support peut également être en matériau thermoformable pour obtenir des objets ayant différentes formes et volumes. En particulier, le support en matériau thermoformable peut comprendre une ou plusieurs pistes conductrices telles que présentées ci-dessus et une ou plusieurs dispositifs de type LED interconnectés électriquement entre eux via les pistes conductrices. Dans ce cas particulier, la mise en forme du support peut être réalisée avant ou après le routage des pistes conductrices sur le support, par exemple via la mise en œuvre d'une technique d'incrustation adaptée aux formes en 3D. En outre, les dispositifs LED peuvent être posés avant ou après formation.

Avantageusement, le support peut être un support déformable souple de type Thermo Plastique Elastomères (TEP). Ces supports en TEP permettant notamment de réaliser des tissages de textile lumineux pouvant ainsi s'adapter à différentes courbures et notamment être déformable suivant différentes directions de l'espace.

Il est ainsi possible d'obtenir une pièce mécanique intégrant au moins un dispositif émetteur de rayonnement lumineux décrit ci-avant.

En pratique, dispositif émetteur tel que décrit ci-dessus peut également comprendre un système de détrompage configuré pour permettre un positionnement correct des dispositifs de type LED sur le support. Ce détrompage peut par exemple être localisé sur ledit support du dispositif émetteur ou encore sur ledit support pour dispositif LED. En outre, le détrompeur peut être sous la forme d'une perforation de forme particulière sur le support du dispositif émetteur, ou d'un code couleur, ou encore résulter d'une forme particulière du support pour dispositif LED permettant de différencier les structures de connexion entre elles.

Globalement, le procédé de fabrication du dispositif émetteur de rayonnement lumineux décrit ci-avant peut comprendre :
- la réalisation d'au moins une piste conductrice par solidarisation de fils conducteurs à un support sur tout ou partie de leur longueur et selon un motif d'interconnexion, le support étant délimité par des première et deuxième faces opposées définissant entre elles une épaisseur du support, tout ou partie des fils conducteurs présentant au moins une portion de contact exposée en direction d'au moins l'une des première et deuxième faces du support ;
- le montage et la connexion, à la piste conductrice, d'au moins un dispositif de type LED apte à générer un rayonnement lumineux dans une gamme de longueurs d'onde prédéfinie et comprenant deux plages de contact électrique, chacune des plages de contact du dispositif de type LED étant reportée en regard d'une portion de contact d'un des fils conducteurs, et étant connectée électriquement à ladite portion de contact.

Comme explicité ci-avant, la solution de l'invention autorise une certaine flexibilité dans le procédé de fabrication.

Selon un mode de réalisation de l'invention, la réalisation de la piste conductrice comprend la formation sur le support d'une zone déformable dans au moins une direction de déformation et dans laquelle une portion d'au moins l'un desdits fils conducteurs est positionnée selon un motif autorisant la déformation de ladite zone déformable et de la piste conductrice selon ladite direction de déformation, sans rupture des fils conducteurs.

Selon un mode de réalisation, la solidarisation des fils conducteurs au support est obtenue par incrustation des fils conducteurs dans l'épaisseur du support à partir d'une des première et deuxième faces du support.

Selon un autre mode de réalisation, la solidarisation des fils conducteurs est obtenue par collage des fils conducteurs sur l'une des première et deuxième faces du support.

Selon une variante, la piste conductrice est réalisée avant le montage et la connexion électrique du dispositif LED à la piste conductrice.

Selon une autre variante, le montage du dispositif de type LED au support est réalisé avant la réalisation de la piste conductrice et la connexion des portions de contact des fils conducteurs aux plages de contact.

Avantageusement, le procédé comprend en outre la réalisation d'au moins un logement dans l'épaisseur du support, le logement étant au moins ouvert sur l'une des première et deuxième faces du support et comprenant au moins le dispositif de type LED et les portions de contact auxquels le dispositif de type LED est connectée.

De façon pratique, selon une version, le procédé de fabrication peut donc comprendre les étapes suivantes :
- tout d'abord, la réalisation de la piste conductrice par incrustation de fils conducteurs dans l'épaisseur du support selon un motif d'interconnexion prédéfini ;
- ensuite le montage et la connexion électrique du ou des dispositifs LED au support et notamment à la piste conductrice.

De façon pratique, selon une autre version, le procédé de fabrication peut donc comprendre les étapes successives suivantes :
- tout d'abord le montage du ou des dispositifs de type LED au support ;
- ensuite la réalisation de la piste conductrice par incrustation de fils conducteurs dans l'épaisseur du support selon un motif d'interconnexion prédéfini, incluant la connexion des portions de contact des fils conducteurs aux plages de contact des dispositifs de type LED.

Selon encore une autre version, le procédé de fabrication peut comprendre les étapes suivantes :
- tout d'abord, la réalisation d'un ou de plusieurs logements dans l'épaisseur du support, le ou les logement(s) étant ouvert(s) sur la première face du support ;
- le montage du ou des dispositifs LED au support, chaque dispositif LED étant disposé sur la surface de la première face du support ou dans un des logements ;
- la réalisation de la piste conductrice par incrustation de fils conducteurs dans l'épaisseur du support selon un motif d'interconnexion prédéfini, chaque fil conducteur comprenant au moins une portion de contact connecté à une des plages d'un des dispositifs lumineux LED.

Selon encore une autre version, le procédé de fabrication peut comprendre les étapes suivantes :
- la réalisation d'un ou de plusieurs logements dans l'épaisseur du support, chaque logement étant destiné à recevoir au moins un dispositif LED, à savoir un module ou une puce LED ;
- la réalisation de la piste conductrice par incrustation de fils conducteurs dans l'épaisseur du support selon un motif d'interconnexion prédéfini, tout ou partie des logements étant de préférence interconnectés entre eux;
- le montage du ou des dispositifs LED dans les logements, et la connexion électrique de chaque dispositif LED à des portions de contact.

Selon encore un autre mode de réalisation, le procédé de fabrication peut comprendre les étapes suivantes :
- la réalisation de la piste conductrice par incrustation de fils conducteurs dans l'épaisseur du support selon un motif d'interconnexion prédéfini ;
- le montage et la connexion électrique du ou des dispositifs LED au support et notamment à la piste conductrice, chaque dispositif LED étant une puce LED ;
- le dépôt d'un corps d'encapsulation sur le support recouvrant au moins la puce LED et une partie des fils conducteurs connectés à la puce LED.

Le corps d'encapsulation peut être réalisé via le dépôt de goutte de résine de silicone ou encore via le dépôt d'un film. A titre d'exemple, il peut être envisagé le dépôt du film par sérigraphie ou par une technique de laminage à chaud. De préférence, des luminophores sont disposés sur le support et dans le corps d'encapsulation. De préférence, des luminophores sont intégrés dans le corps d'encapsulation.

Le dispositif émetteur de rayonnement lumineux ainsi obtenu peut être utilisé directement ou être incorporé dans d'autres objets. Par exemple, il peut être découpé, mis en volume manuellement ou par thermoformage, ou encore surmoulé pour former des pièces plus massives incorporant des dispositifs lumineux, par exemple des pare-chocs lumineux. Bien entendu, un support en matériau adapté à la technique de surmoulage est avantageusement utilisé.

### Brève description des dessins

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un dispositif émetteur de lumière selon un mode de réalisation de l'invention ;
- la figure 2 est une vue en coupe d'une représentation schématique de l'incrustation d'un fil conducteur dans l'épaisseur d'un support, selon un mode de réalisation particulier de l'invention ;
- la figure 3A est une représentation schématique d'un dispositif émetteur de lumière selon un mode de réalisation de l'invention, dans lequel le dispositif lumineux est positionné sur les portions de contact des fils conducteurs ;
- la figure 3B est une vue en coupe du dispositif de la figure 3A ;
- la figure 4 est une représentation schématique d'un dispositif émetteur de lumière selon un autre mode de réalisation de l'invention, dans lequel le dispositif lumineux est positionné sous les portions de contact des fils conducteurs ;
- la figure 5A est une représentation schématique d'un dispositif émetteur de lumière selon un autre mode de réalisation de l'invention, dans lequel le dispositif lumineux est positionné dans un logement du support ;
- la figure 5B est une représentation schématique d'un dispositif émetteur de lumière selon un autre mode de réalisation de l'invention, les portions de contact sont enchâssées dans les plages de contact ;
- la figure 6 est une représentation schématique de la face arrière d'un module LED intégrant des ailettes de contact, selon un autre mode de réalisation de l'invention ;
- la figure 7 est une représentation schématique d'un dispositif émetteur de lumière selon un autre mode de réalisation de l'invention ;
- la figure 8 est une représentation schématique d'un dispositif émetteur de lumière selon un autre mode de réalisation de l'invention ;
- les figures 9A, 10A et 11A sont des représentations schématiques d'un dispositif émetteur de lumière selon différents modes de réalisation dans lesquels la piste conductrice présente des zones étirables, le support étant en configuration non étirée ;
- les figures 9B, 10B et 11B sont des représentations schématiques des dispositifs émetteurs de lumière des figures 9A, 10A et 11A respectivement, après déformation du support.

On notera que dans ces figures, les mêmes références désignent des éléments identiques ou analogues et les différentes structures ne sont pas à l'échelle. Par ailleurs, seuls les éléments indispensables à la compréhension de l'invention sont représentés sur ces figures pour des raisons de clarté.

### Description détaillée de certains modes de réalisation de l'invention

Il sera décrit ci-après, certains modes de réalisations particuliers exposé ci-avant d'un circuit imprimé par l'utilisation de fils conducteurs solidarisés à un support, par collage ou incrustation de ces fils sur ou dans l'épaisseur du support, pour la réalisation de pistes conductrices selon un motif prédéfini d'interconnexion, et pour interconnecter plusieurs composants entre eux, notamment des dispositifs de type LED, tels que des modules LED ou puces LED.

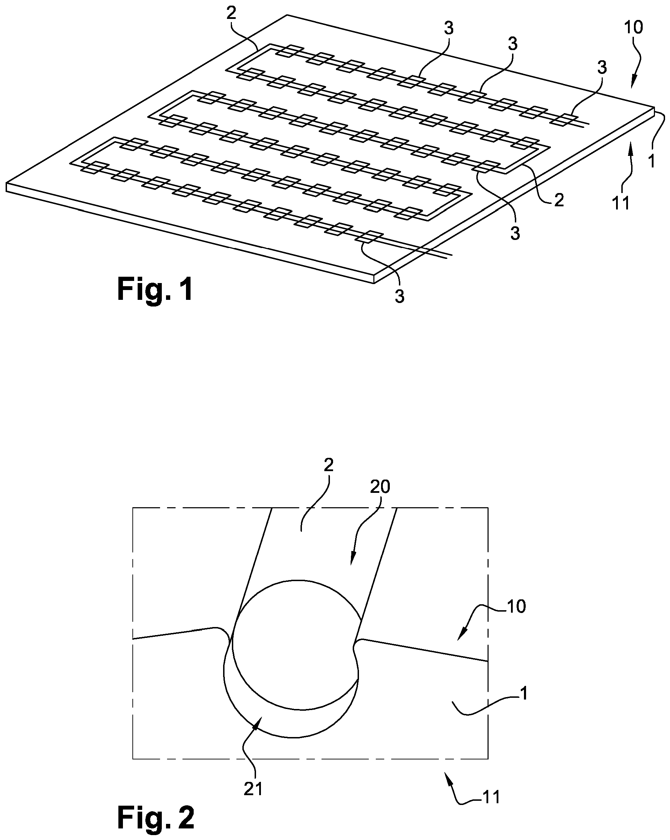

La figure 1 illustre un dispositif émetteur de rayonnement lumineux selon un mode de réalisation de l'invention, dans lequel des dispositifs de type LED 3 sont montés en parallèle sur une face d'un support 1 flexible. Chaque dispositif LED 3 comprend généralement deux plages de contact électrique qui peuvent être formées sur une même face d'un substrat ou d'une embase électriquement isolante. Les dispositifs LED 3 sont électriquement interconnectés entre eux, via leurs plages de contact, au moyen de pistes conductrices réalisées sur le support 1. Ces pistes conductrices peuvent notamment être réalisées par incrustation de fils conducteurs 2 dans l'épaisseur du support 1 à partir de la face recevant les dispositifs LED 3. Ces pistes conductrices peuvent également être réalisées par simple collage des fils conducteurs sur le support.

Un fil conducteur incrusté dans le support selon un mode de réalisation est illustré à la figure 2. Le support 1 présente donc deux faces opposées, une première face 10 et une deuxième face 11, délimitant l'épaisseur du support. Par exemple, la première face 10 du support 1 est destinée à recevoir les composants à interconnecter, et en particulier les dispositifs LED. Un fil conducteur 2 est inséré, sur tout ou partie de sa longueur, dans l'épaisseur du support 1 à partir de cette première face 10. La profondeur de l'incrustation est telle qu'une partie du fil 2 reste exposée sur la première face 10 du support 1. En d'autres termes, le fil conducteur 2 comprend une portion 20 dite « portion de contact » exposée sur la première face 10 du support 1 et une autre portion 21 disposée sous la première face 10 du support 1. Cette portion de contact 20 est destinée à être connectée aux plages de contact des dispositifs lumineux LED 3.

En pratique, les portions de contact 20 des fils conducteurs 2 peuvent effleurer la surface de la première face 10 du support 1 ou peuvent être en saillie par rapport à la surface de cette première face 10, comme illustré sur la figure 1. Ces deux configurations permettent une connexion directe des composants à la piste conductrice.

Ainsi, il suffit de reporter chacune des plages de contact des dispositifs LED en regard d'une portion de contact d'un des fils conducteurs de la piste conductrice, et de connecter ces plages de contact aux portions de contact respectif pour assurer l'interconnexion électrique entre les dispositifs lumineux LED. Par exemple, la connexion directe d'une plage de contact à une portion de contact peut être réalisée par soudure par thermocompression.

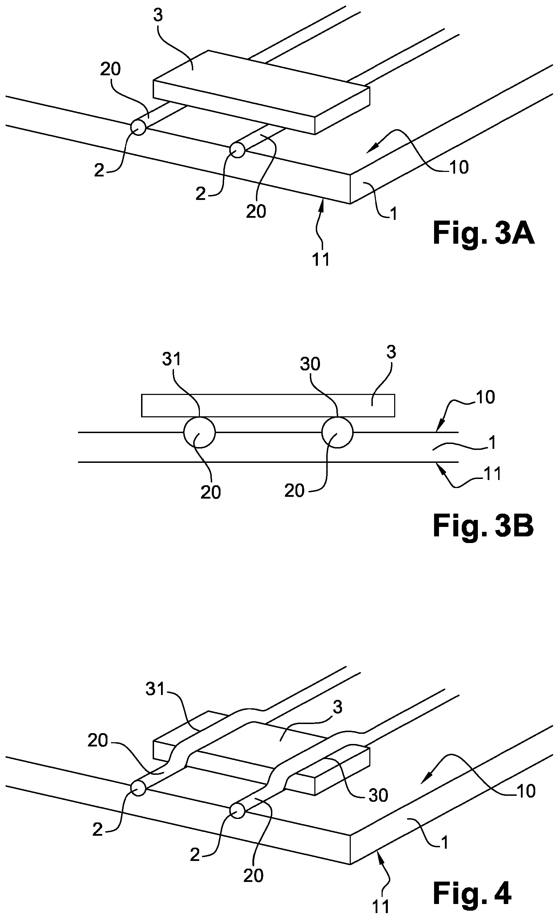

Selon un mode de réalisation illustré aux figures 3A et 3B, le dispositif LED 3 peut être disposé sur la surface de la première face 10 du support 1, au-dessus des portions de contact 20, dans la direction de la deuxième face 11 vers la première face 10, et les plages de contact 30, 31 du dispositif LED 3 sont en contact direct avec les portions de contact 20 des fils conducteurs 2.

En termes de procédé, il peut être envisagé les étapes suivantes :
- tout d'abord, réalisation de la piste conductrice par incrustation de fils conducteurs dans l'épaisseur du support à partir de la première face du support et selon un motif d'interconnexion prédéfini ;
- puis montage des dispositifs LED sur la première face du support en disposant les plages de connexion en regard des portions de contact et connexion des plages de contact aux portions de connexion, par exemple par thermocompression.

Selon une variante illustrée à la figure 4, le dispositif LED 3 peut être disposé sur la surface de la première face 10 du support 1, au-dessous des portions de contact 20, dans la direction de la deuxième face 11 vers la première face 10. Les plages de contact 30, 31 du dispositif LED 3 sont également en contact direct avec les portions de contact 20 des fils conducteurs 2. Dans ce cas particulier, les fils 2 sont incrustés dans l'épaisseur du support sur une partie de leur longueur, les portions de contact 20 chevauchant les plages de contact du dispositif LED 3.

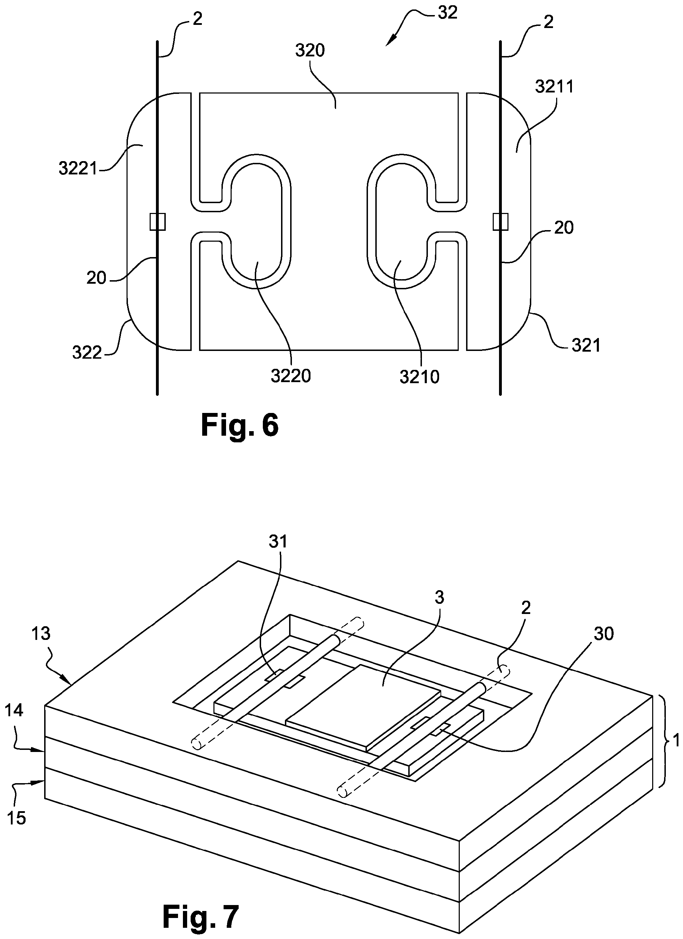

Selon une autre variante, il est également possible de prévoir des plages de contact d'épaisseur inférieure au corps central du dispositif LED pour limiter l'épaisseur totale du produit et ou également permettre de modifier ou ajuster les angles de sortie des flux lumineux. Par exemple, les plages de contact du dispositif lumineux LED peuvent se présenter sous la forme d'ailettes s'étendant latéralement du corps central. En pratique, le dispositif LED peut comprendre un support adapté pour un soudage par thermocompression sur lequel sont positionnés un ou plusieurs puces ou modules LED. Le substrat comprend au moins une structure recevant une ou plusieurs puces LED ou une ou plusieurs modules LED, et des structures de connexion configurées pour assurer la connexion électrique entre les puces ou modules LED et la piste conductrice, via la soudure par exemple. Un exemple d'un tel support pour LED est illustré à la figure 6. Le substrat 32 présente une structure centrale 320 destinée à recevoir au moins une puce LED, ainsi que deux structures latérales 321, 322 sensiblement identiques. Un exemple d'une telle réalisation est illustré à la figure 6. Chaque structure latérale 321, 322 se présente sous la forme d'une ailette et est formée d'une première portion 3210, 3220 et d'une deuxième portion 3211, 3221. La première portion 3210, 3220 est destinée à être reliée électriquement à l'une des électrodes de la puce LED, et la deuxième portion 3211, 3221 forme la plage de contact et est destinée à être connectée à l'une des portions de contact 20 d'un des fils conducteurs 2 de la piste conductrice. Bien entendu, le design particulier illustré à la figure 6 n'est donné qu'à titre d'exemple, d'autres formes et dispositions sont envisageables. En outre, il est également possible de disposer plusieurs puces ou modules LED de même type ou de différents types, sur une même structure centrale, chaque électrode de chacune des puces LED étant reliée électriquement à l'une des structures latérales.

En termes de procédé, il peut être envisagé les étapes suivantes :
- tout d'abord, montage des dispositifs LED au support ;
- puis, réalisation de la piste conductrice par incrustation de fils conducteurs dans l'épaisseur du support selon un motif d'interconnexion prédéfini, incluant la connexion des portions de contact des fils conducteurs aux plages de contact des dispositifs LED.

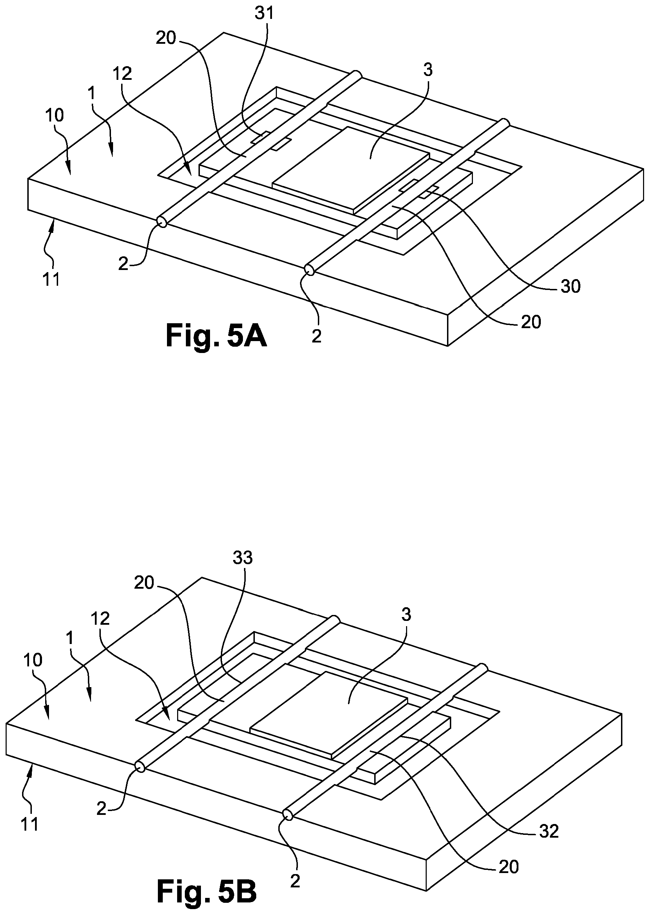

Selon une autre mode de réalisation, le dispositif LED peut être disposé dans un logement 12 formé dans l'épaisseur du support 1, le logement 12 étant ouvert sur la première face 10 du support 1. De même, comme pour le mode de réalisation précédent, les dispositifs LED peuvent être connectés à la piste conductrice de sorte que les portions de contact 20 sont situées sur les plages de contact 30, 31, comme illustré à la figure 5A. La connexion électrique entre les portions de contact et les plages de contact peut être réalisée par tous moyens adaptés, notamment par collage, soudage par thermocompression ou par clipsage. Par ailleurs, il est également possible d'envisager l'incrustation ou le collage des fils conducteurs dans le fond du logement. Dans ce cas, les plages de contact du dispositif lumineux LED disposé dans le logement peuvent être disposées sur les portions de contact. En pratique, le logement est généralement réalisé avant l'incrustation ou le collage des fils conducteurs dans le support.

Comme illustré à la figure 5B, il est également possible de prévoir une fixation et connexion du dispositif LED par « clipsage » des portions de contact aux plages de contact. Par exemple, chaque plage de contact peut comprendre une rainure 32, 33 dimensionnée et configurée pour recevoir et maintenir une portion de contact. La rainure peut notamment être recouverte d'une couche conductrice. Ainsi, il suffit d'enchâsser les portions de contact dans les rainures pour assurer à la fois la connexion et la fixation des portions de contact aux plages de contact.

L'utilisation de fils conducteurs permet également d'inclure directement des composants, tels que des résistances ou des radiateurs, sur les pistes. En effet, de tels composants peuvent être formés par une partie d'un fil conducteur reliant ou non deux dispositifs LED.

En outre, il peut également être avantageux d'utiliser un fil conducteur gainé, comme par exemple un fil conducteur en en cuivre émaillé, puisqu'il est dans ce cas possible de réaliser des pistes incluant des chevauchements de fils. L'élimination de la couche isolante peut être obtenue au moment de la connexion électrique des plages de contact aux portions de contact par une soudure par thermocompression.

Bien entendu, il est possible de disposer plusieurs dispositifs LED, montés en série et/ou en parallèle entre eux, sur un même support.

En pratique, il est possible de router les deux faces opposées du support, par incrustation ou collage de fils conducteurs selon l'une des variantes décrites ci-avant. Il est également possible de prévoir des logements traversant l'épaisseur du support dans lesquels sont exposées les portions de contact, et de connecter directement les dispositifs LED à ces portions contact dans ces logements. Il est ainsi possible de disposer des dispositifs LED sur les deux faces opposées du support et de réaliser ainsi des objets émettant dans plusieurs directions.

Selon un autre mode de réalisation illustré à la figure 7, le support 1 peut être formé d'une première couche 13 intégrant les fils conducteurs 2 et les dispositifs LED 3, une deuxième couche 14 sur l'une des faces de la première couche et faisant office de surface de guide d'onde pour les rayonnements lumineux générés par les dispositifs LED, et une troisième couche 15 disposée sur la deuxième couche 14 et servant de surface de sortie du rayonnement lumineux. Les première et deuxième couches 13, 14 peuvent former une unique couche jouant le rôle de guide d'onde et intégrant les fils conducteurs. Selon une variante, l'extraction des rayonnements lumineux peut être réalisée via les faces latérales de la deuxième couche 14. Il est également possible d'occulter tout ou partie des faces latérales de la deuxième couche 14, via par exemple des caches portant des surfaces réfléchissantes. Dans ce cas de figure, les rayonnements lumineux peuvent être extraits via la troisième couche qui peut être munie de perforation, ou qui présente des propriétés optiques permettant par exemple d'obtenir une lumière diffuse.

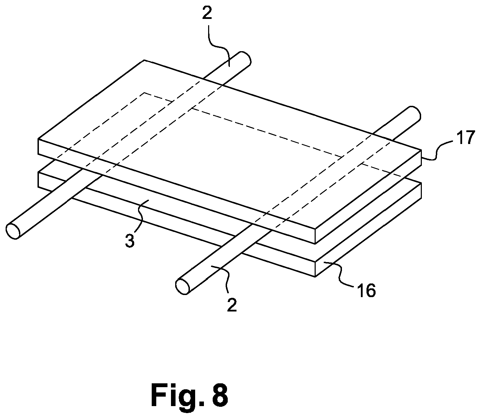

Dans un autre mode de réalisation illustrée à la figure 8, les fils conducteurs 2 ainsi qu'un dispositif LED sont pris en sandwich entre deux substrats 16, 17. Le support peut être constitué par les deux substrats 16, 17 ou peut être constitué par l'un des deux substrats 16, 17. Les fils conducteurs 2 peuvent être formés sur le premier substrat 16 par simple collage des fils sur ce premier substrat 16. Le dispositif peut être connecté aux portions de contact des fils via l'une des variantes explicitées ci-dessus, à savoir par soudure ou par collage. Le deuxième substrat 17 peut recouvrir totalement les fils conducteurs et le dispositif LED. Dans ce cas, il est préférable qu'au moins l'un des deux substrats, par exemple le deuxième substrat, présente des propriétés optiques autorisant par exemple la transmission de tout ou partie des rayonnements lumineux émis par le dispositif LED. Il est également possible de prévoir une fenêtre dans l'un ou l'autre des deux substrats, en regard du dispositif LED de manière à autoriser le passage des rayonnements lumineux.

La solution consistant à réaliser des pistes conductrices par l'utilisation de fils conducteurs, via un collage ou une incrustation de fils conducteurs offre donc une grande flexibilité tant dans le motif des pistes conductrices que dans le montage et l'interconnexion des dispositifs lumineux LED sur ces pistes.

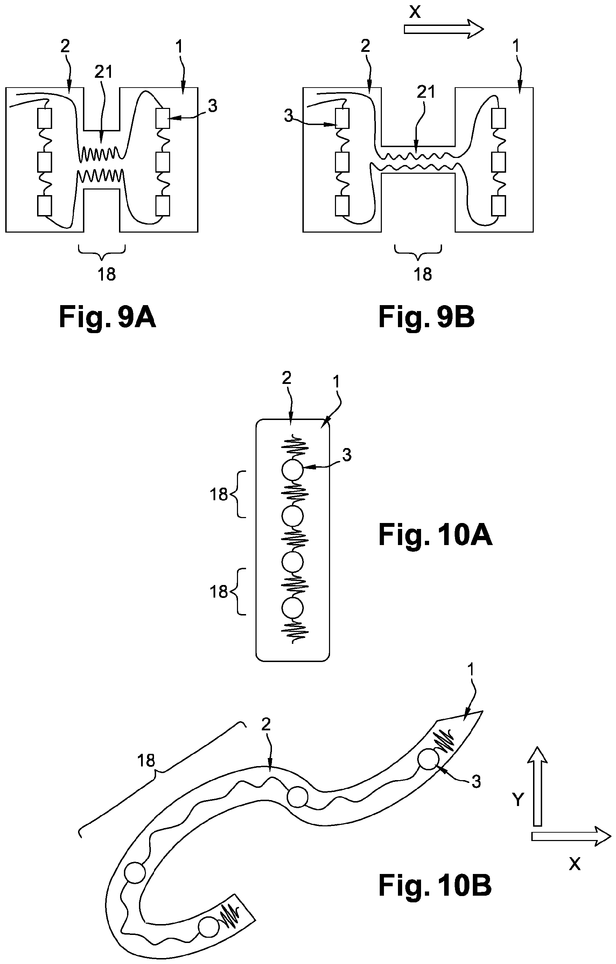

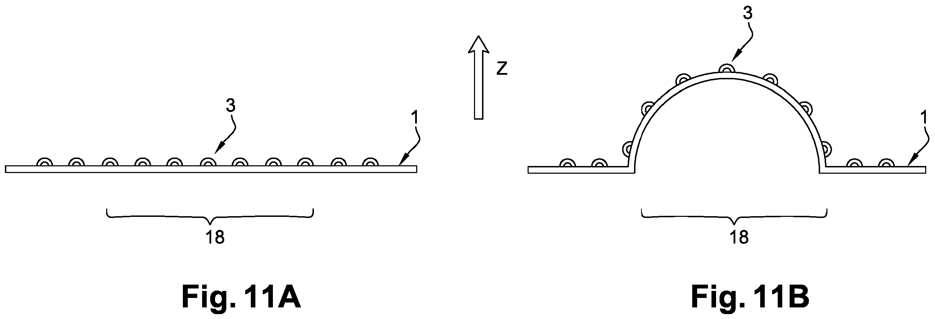

Selon un mode de réalisation illustré aux figures 9A à 11A, il est possible de router les pistes conductrices de manière à autoriser une déformation du support (1) sans rupture de conduction dans la piste conductrice. Pour ce faire, on peut notamment prévoir une zone dite « déformable » (18), par exemple étirable, sur le support (1) dans laquelle les fils conducteurs de la piste conductrice sont positionnés selon un motif (21) qui autorise une déformation de la piste dans une direction souhaitée sans risque de rupture des fils conducteurs. Dans les exemples illustrés aux figures 9A, 10A et 11A, les fils conducteurs présentent, outres les portions de contacts destinées à être mises en contact avec des composants électriques, tel que le dispositif de type LED (3), des portions routées selon un motif particulier, par exemple en zigzag (21), sur le support (1). Bien entendu, d'autres motifs de routage sont possibles en fonction des déformations envisagées. Comme illustré aux figures 9B, 10B et 11B, lors de la déformation du support dans la direction envisagée, la piste conductrice suit les déformations du support sans rupture de ligne grâce aux motifs de routage. Par exemple, sur la figure 9B, les motifs sont configurés pour autoriser l'étirement de la zone étirable dans la direction X sensiblement parallèlement aux faces du support. Bien entendu, des zones étirables dans la direction Y perpendiculaire à la direction X sont également envisageables. Il est ainsi possible d'envisager pour une même zone étirable différentes directions d'étirement (figure 10B) et notamment suivant la direction Z perpendiculaire aux directions X et Y précédentes, pour réaliser des structures en volume. Par exemple, des zones étirables peuvent être localisées entre deux ou plusieurs LEDs ou tout autre composant électronique. Il est ainsi possible de réaliser des dispositifs lumineux flexibles capables de s'adapter à des courbures spécifiques.

La solution de présente invention est notamment adaptée pour la réalisation de dispositif émetteur de rayonnement lumineux de dimensions micrométriques ou non. En particulier, la solution est bien adaptée pour le montage de dispositif LED sur un circuit imprimé formé d'un support flexible ou rigide. La solution offre une grande flexibilité en termes de type, forme et dimension de support, de schéma d'interconnexion, de densité de dispositifs LED à monter.

## Revendications

1. Dispositif émetteur d'un rayonnement lumineux comprenant :
- au moins un dispositif de type LED (3) apte à générer un rayonnement lumineux dans une gamme de longueurs d'onde prédéfinie, et comprenant au moins deux plages de contact (30, 31) électrique ;
- un support (1) délimité par des première et deuxième faces (10, 11) opposées définissant entre elles une épaisseur du support (1), ledit support (1) portant au moins ledit dispositif de type LED (3) et au moins une piste électrique conductrice ;
- la piste électrique est formée de fils conducteurs (2), tout ou partie des fils conducteurs présentant au moins une portion de contact (20) exposée en direction d'au moins l'une des première et deuxième faces du support (1) ;
- chacune des plages de contact (30, 31) du dispositif de type LED (3) étant positionnée en regard d'une portion de contact (20) d'un des fils conducteur (2), et étant connectée électriquement à ladite portion de contact (20) ;
**caractérisé en ce que**:
- le dispositif de type LED est formé d'un substrat comprenant au moins une structure de réception (320) et au moins une paire de structures de connexion (321, 322), la structure de réception recevant au moins une puce ou module LED, chaque structure de connexion étant formée d'au moins d'une première portion (3210) solidaire d'une deuxième portion (3220), ladite première portion étant reliée électriquement à l'une des électrodes de la puce ou du module LED, et la deuxième portion formant une desdites plages de contact connectée à l'une des portion de contact (20) d'un des fils conducteurs (2) de la piste conductrice ;
- chaque fil conducteur est incrusté dans l'épaisseur du support (1) à partir d'une face d'incrustation formée par la première ou la deuxième face du support (1) ;
- les portions de contact (20) de chaque fil conducteur sont disponibles pour être connectées électriquement.

2. Dispositif selon la revendication 1, **caractérisé en ce que** le support (1) est déformable (18) dans au moins une direction de déformation et dans laquelle une portion d'au moins l'un desdits fils conducteurs (2) est positionnée selon un motif (21) autorisant la déformation du support (1) et de la piste conductrice selon ladite direction de déformation, sans rupture des fils conducteurs (2).

3. Dispositif selon la revendication 1, **caractérisé en ce que** le support est pourvu d'au moins un logement ouvert sur au moins l'une des faces du support, ledit logement comprenant au moins ledit dispositif de type LED et au moins les portions de contact auxquelles ledit dispositif de type LED est connecté.

4. Dispositif selon la revendication 1 ou 2, **caractérisé en ce que** le support (1) est formé de deux substrats enserrant les fils conducteurs, et **en ce qu'**au moins l'un des deux substrats comporte au moins un évidement autorisant ladite exposition des portions de contact, ledit dispositif LED étant positionné à l'intérieur dudit évidement.

5. Dispositif selon l'une des revendications 1 à 4, **caractérisé en ce que** la piste conductrice comprend au moins une résistance et/ou un dissipateur thermique formé par au moins l'un des fils conducteurs.

6. Dispositif selon l'une des revendications 1 à 5, **caractérisé en ce que** chaque fil conducteur (2) est recouvert d'une gaine isolante, les portions de contact (20) connectées aux plages de contact du dispositif lumineux LED (3) électrodes de la puce LED, étant dépourvue de gaine isolante.

7. Dispositif selon l'une des revendications 1 à 6, **caractérisé en ce qu'**il comprend un système de détrompage configuré pour permettre un positionnement correct des dispositifs de type LED sur le support.

8. Pièce mécanique intégrant au moins un dispositif émetteur de rayonnement lumineux selon l'une des revendications 1 à 7.

9. Procédé de fabrication d'un dispositif émetteur de lumière selon l'une des revendications 1 à 7, **caractérisé en ce qu'**il comprend :
- la réalisation d'au moins une piste conductrice dans un support selon un motif d'interconnexion, le support étant délimité par des première et deuxième faces opposées définissant entre elles une épaisseur du support, tout ou partie des fils conducteurs présentant au moins une portion de contact (20) exposée en direction d'au moins l'une des première et deuxième faces du support (1), chaque fil conducteur étant incrusté dans l'épaisseur du support (1) à partir d'une face d'incrustation formée par la première ou la deuxième face du support (1), les portions de contact (20) de chaque fil conducteur étant disponibles pour être connectées électriquement ;
- former au moins un dispositif de type LED à partir d'un substrat comprenant au moins une structure de réception (320) et au moins une paire de structures de connexion (321, 322), la structure de réception recevant au moins une puce ou module LED, chaque structure de connexion étant formée d'au moins d'une première portion (3210) solidaire d'une deuxième portion (3220), ladite première portion étant reliée électriquement à l'une des électrodes de la puce ou du module LED, et la deuxième portion formant une desdites plages de contact connectée à l'une des portion de contact (20) d'un des fils conducteurs (2) de la piste conductrice ;
- le montage et la connexion, à la piste conductrice, d'au moins un dispositif de type LED (3) apte à générer un rayonnement lumineux dans une gamme de longueurs d'onde prédéfinie et comprenant deux plages de contact (30, 31) électrique, chacune des plages de contact (30, 31) du dispositif de type LED (3) étant reportée en regard d'une portion de contact (20) d'un des fils conducteur (2), et étant connectée électriquement à ladite portion de contact (20).

10. Procédé de fabrication selon la revendication 9, la réalisation de la piste conductrice comprend la formation sur le support (1) d'une zone déformable (18) dans au moins une direction de déformation et dans laquelle une portion d'au moins l'un desdits fils conducteurs (2) est positionnée selon un motif (21) autorisant la déformation de ladite zone déformable et de la piste conductrice selon ladite direction de déformation, sans rupture des fils conducteurs (2).

## Patentansprüche

1. Lichtemittierende Vorrichtung mit:
- mindestens einer Vorrichtung vom LED-Typ (3), die in der Lage ist, eine Lichtstrahlung in einem vordefinierten Wellenlängenbereich zu erzeugen, und die zwei mindestens zwei elektrische Kontaktflächen (30, 31) aufweist;
- einen Träger (1), der durch eine erste und eine zweite einander gegenüberliegende Seite (10, 11) begrenzt ist, diese definieren zusammen die Dicke des Trägers, dieser Träger, der mindestens die Vorrichtung vom LED-Typ (3) und mindestens eine elektrische Leiterbahn trägt;
- die Leiterbahn besteht aus leitenden Drähten (2), die mindestens einen Kontaktabschnitt (20) aufweisen, der in Richtung mindestens der ersten und/ oder der zweiten Trägerseiten (1) orientiert ist;
- jede der Kontaktflächen (30, 31) der Vorrichtung vom LED-Typ (3) ist gegenüber einem Kontaktabschnitt (20) eines der Leiter angeordnet und ist elektrisch mit diesem Kontaktabschnitt (20) verbunden.
**dadurch gekennzeichnet, dass**:
- die Vorrichtung vom LED-Typ aus einem Substrat besteht, das mindestens eine Aufnahmestruktur (320) und mindestens ein Paar Verbindungsstrukturen (321, 322) enthält, die Aufnahmestruktur nimmt dabei mindestens einen Chip oder ein LED-Modul auf, jede Verbindungsstruktur besteht aus mindestens einem ersten Abschnitt (3210), der mit einem zweiten Abschnitt (3220) fest verbunden ist, dabei ist dieser erste Abschnitt elektrisch verbunden mit einer der Elektroden des Chips oder des LED- Moduls und der zweite Abschnitt, der eine der erwähnten Kontaktflächen bildet, ist verbunden mit einem der Kontaktabschnitte (20) eines Leiterdrahts (2) der Leiterbahn;
- jeder Leiterdraht ist in die Dicke des Trägers (1) eingebettet, ausgehend von einer Einbettungsseite, die von der ersten oder zweiten Seite des Trägers (1) gebildet wird;
- die Kontaktabschnitte (20) jedes Leiterdrahts stehen zur elektrischen Verbindung bereit.

2. Vorrichtung nach Anspruch 1, **dadurch gekennzeichnet, dass** der Träger (1) in mindestens eine Verformungsrichtung verformbar (18) ist und bei der ein Abschnitt mindestens eines der Leiterdrahts (2) entsprechend einem Muster (21) angeordnet ist, das eine Verformung des Trägers (1) und der Leiterbahn entsprechend dieser Verformungsrichtung ohne Bruch der Leiter (2) ermöglicht.

3. Vorrichtung nach Anspruch 1, **dadurch gekennzeichnet, dass** der Träger mit mindestens einer Unterbringung versehen ist, die auf mindestens einer der Trägerseiten offen ist, diese Unterbringung enthält mindestens die erwähnte Vorrichtung vom LED - Typ und mindestens die Kontaktabschnitte, mit denen diese Vorrichtung vom LED - Typ verbunden ist.

4. Vorrichtung nach Anspruch 1 oder 2, **dadurch gekennzeichnet, dass** der Träger (1) aus zwei Substraten besteht, die die Leiter umschließen und dadurch, dass mindestens eines der beiden Substrate mindestens eine Aussparung enthält, die diese Exposition der Kontaktabschnitte ermöglicht, die erwähnte LED - Vorrichtung ist innerhalb dieser Aussparung untergebracht.

5. Vorrichtung nach einem der Ansprüche 1 bis 4, **dadurch gekennzeichnet, dass** die Leiterbahn mindestens einen Widerstand und/ oder einen Kühlkörper enthält, der aus mindestens einem der Leiterdrähte besteht.

6. Vorrichtung nach einem der Ansprüche 1 bis 5, **dadurch gekennzeichnet, dass** jeder Leiterdraht (2) von einer isolierenden Hülle umgeben ist, die Kontaktabschnitte (20), die mit den Kontaktflächen der LED - Leuchtvorrichtung (3) oder Elektroden des LED - Chips verbunden sind, sind nicht mit einer Isolierhülle bedeckt.

7. Vorrichtung nach einem der Ansprüche 1 bis 6, **dadurch gekennzeichnet, dass** sie ein Kodiersystem enthält, konfiguriert um die richtige Positionierung der LED - Typ - Vorrichtungen auf dem Träger zu ermöglichen.

8. Mechanisches Teil, das mindestens eine lichtabstrahlende Vorrichtung nach einem der Ansprüche 1 bis 7 enthält.

9. Herstellungsverfahren einer lichtabstrahlenden Vorrichtung nach einem der Ansprüche 1 bis 7, **dadurch gekennzeichnet, dass** es umfasst:
- die Herstellung mindestens einer Leiterbahn in einem Träger nach einem Verbindungsmuster, der Träger wird dabei durch die einander gegenüberliegenden ersten und zweiten Seiten begrenzt, die zwischen sich eine Dicke des Trägers definieren, alle oder Teile der Leiterdrähte weisen mindestens einen Kontaktabschnitt (20) auf, der in Richtung mindestens einer der beiden ersten und zweiten Seiten des Trägers (1) exponiert ist, jeder Leiterdraht ist dabei in die Dicke des Trägers (1) eingebettet, ausgehend von einer Einbettungsseite, die von der ersten oder zweiten Seite des Trägers (1) gebildet wird, die Kontaktabschnitte (20) jedes Leiterdrahts stehen zur elektrischen Verbindung zur Verfügung;
- die Bildung mindestens einer Vorrichtung vom LED-Typ, ausgehend von einem Substrat, mit mindestens einer Aufnahmestruktur (320) und mindestens einem Paar Verbindungsstrukturen (321, 322), die Aufnahmestruktur nimmt mindestens ein Chip- oder LED- Modul auf, jede Verbindungsstruktur besteht aus mindestens einem ersten Abschnitt (3210), der fest verbunden ist mit einem zweiten Abschnitt (3220), dabei ist dieser erste Abschnitt elektrisch verbunden mit einer der Elektroden des Chips oder des LED- Moduls und der zweite Abschnitt, der eine der erwähnten Kontaktflächen bildet, ist verbunden mit einem der Kontaktabschnitte (20) eines Leiterdrahts (2) der Leiterbahn.
- die Montage und Verbindung zur Leiterbahn, mindestens einer Vorrichtung vom LED - Typ (3), die in der Lage ist, eine Lichtstrahlung in einer vorjehr festgelegten Wellenlängenbereich zu erzeugen und die zwei elektrische Kontaktflächen (30, 31) umfasst, jede der Kontaktflächen (30, 31) der Vorrichtung vom LED - Typ (3) ist dabei gegenüber einem Kontaktabschnitt (20) eines Leiterdrahtes (2) versetzt und elektrisch mit dem erwähnten Kontaktabschnitt (20) verbunden.

10. Herstellungsverfahren nach Anspruch 9, die Herstellung der Leiterbahn umfasst die Bildung auf dem Träger (1) eines verformbaren Bereichs (18) in mindestens einer Verformungsrichtung und in der ein Abschnitt mindestens eines dieser Leiterdrähte (2) entsprechend einem Muster (21) angeordnet ist, das eine Verformung dieses Verformungsbereichs und der Leiterbahn entsprechend dieser Verformungsrichtung erlaubt, ohne dass die Leiterdrähte (2) brechen.

## Claims

1. A light radiation emitting device comprising:
- at least one LED-type device (3) capable of generating a light radiation in a predefined wavelength range and comprising at least two electrical contact pads (30, 31);
- a support (1) delimited by opposite first and second sides (10, 11) defining together a thickness of the support (1), said support (1) supporting at least said LED-type device (3) and at least one electrically-conductive track;
- the electric track is formed of conductive wires (2), all or part of the conductive wires having at least one contact portion (20) exposed towards at least one of the first and second sides of the support (1);
- each of the contact pads (30, 31) of the LED-type device (3) is positioned opposite a contact portion (20) of one of the conductive wires (2) and is electrically connected to said contact portion (20);
**characterized in that**:
- the LED-type device is formed of a substrate comprising at least one reception structure (320) and at least one pair of connection structures (321, 322), the reception structure receiving at least one LED chip or module, each connection structure being formed of at least a first portion (3210) forming one block with a second portion (3220), said first portion being electrically coupled to one of the electrodes of the LED chip or module, and the second portion forming one of said contact pads connected to one of the contact portions (20) of one of the conductive wires (2) of the conductive track;
- each conductive wire is embedded within the thickness of the support (1) from an embedment surface formed by the first or the second side of the support (1);
- the contact portions of each conductive wire are available to be electrically connected.

2. The device of claim 1, **characterized in that** the support (1) is deformable in at least one deformation direction and wherein a portion of at least one of said conductive wires (2) is positioned according to a pattern (21) authorizing the deformation of the support (1) and of the conductive track in said deformation direction, with no breakage of the conductive wires (2).

3. The device of claim 1, **characterized in that** the support is provided with at least one housing open on at least one of the sides of the support, said housing comprising at least said LED-type device and at least the contact portions to which said LED-type device is connected.

4. The device of claim 1 or 2, **characterized in that** the support (1) is formed of two substrates enclosing the conductive wires, and **in that** at least one of the two substrates comprises at least one recess authorizing said exposure of the contact portions, said LED device being positioned inside of said recess.

5. The device of any of claims 1 to 4, **characterized in that** the conductive track comprises at least one resistor and/or one heat sink formed by at least one of the conductive wires.

6. The device of any of claims 1 to 5, **characterized in that** each conductive wire (2) is covered with an insulating sheath, the contact portions (20) connected to the contact pads of the LED luminous device (3) or to the electrodes of the LED chip, having no insulating sheath.

7. The device of any of claims 1 to 6, **characterized in that** it comprises a keying system configured to allow a correct positioning of the LED-type devices on the support.

8. A mechanical part integrating at least one light radiation emitting device of any of claims 1 to 7.

9. A method of manufacturing the light-emitting device of any of claims 1 to 7, **characterized in that** it comprises:
- forming at least one conductive track in a support according to an interconnection pattern, the support being delimited by first and second opposite sides defining together a thickness of the support, all or part of the conductive wires having at least one contact portion (20) exposed towards at least one of the first and second sides of the support (1), each conductive wire being embedded within the thickness of the support (1) from an embedment surface formed by the first or the second side of the support (1), the contact portions (20) of each conductive wire being available to be electrically connected;
- forming at least one LED-type device with a substrate comprising at least one reception structure (320) and at least one pair of connection structures (321, 322), the reception structure receiving at least one LED chip or module, each connection structure being formed of at least a first portion (3210) forming one block with a second portion (3220), said first portion being electrically coupled to one of the electrodes of the LED chip or module, and the second portion forming one of said contact pads to be connected to one of the contact portions (20) of one of the conductive wires (2) of the conductive track;
- assembling and connecting to the conductive track of at least one LED-type device (3) capable of generating a light radiation in a predefined wavelength range and comprising two electrical contact pads (30, 31), each of the contact pads (30, 31) of the LED-type device (3) being placed opposite a contact portion (20) of one of the conductive wires (2) and being electrically connected to said contact portion (20).

10. The manufacturing method of claim 14, **characterized in that** the forming of the conductive track comprises forming on the support (1) an area (18) deformable in at least one deformation direction and wherein a portion of at least one of said conductive wires (2) is positioned according to a pattern (21) authorizing the deformation of said deformable area and of the conductive track in said deformation direction with no breakage of the conductive wires (2).
